# FASCICULE DE BREVET EUROPEEN

(11) **EP 2 443 467 B1**
(45) Date de publication et mention de la délivrance du brevet: **13.03.2013**
(21) Numéro de dépôt: 10724094.7
(22) Date de dépôt: 16.06.2010
(51) Int. Cl.: G01R 29/08, G01R 31/12

(54) **DISPOSITIF DE SURVEILLANCE D'UN POSTE ELECTRIQUE HAUTE TENSION ISOLE AU GAZ PAR MESURE DE DECHARGES PARTIELLES**
VORRICHTUNG ZUR ÜBERWACHUNG EINER GASISOLIERTEN HOCHSPANNUNGSUNTERSTATION MITTELS MESSUNG VON TEILENTLADUNGEN
DEVICE FOR MONITORING A GAS-INSULATED HIGH-VOLTAGE SUBSTATION BY MEASURING PARTIAL DISCHARGES

(30) Priorité: 19.06.2009 FR 0954160
(43) Date de publication de la demande: 25.04.2012
(73) Titulaire: ALSTOM Technology Ltd, 5400 Baden (CH)
(72) Inventeur: GAUTSCHI, David, CH-5702 Niederlenz (CH)
(74) Mandataire: Ilgart, Jean-Christophe
(86) Numéro de dépôt international: PCT/EP2010/058469
(87) Numéro de publication internationale: WO 2010/146086

(56) Documents cités:
- EP-A2- 0 134 187
- EP-A2- 0 706 056
- DATABASE INSPEC [Online] THE INSTITUTION OF ELECTRICAL ENGINEERS, STEVENAGE, GB; décembre 2008 (2008-12), LOPEZ-ROLDAN J ET AL: "Optimisation of a sensor for onsite detection of partial discharges in power transformers by the UHF method" XP002574659 Database accession no. 10370141 cité dans la demande & IEEE TRANSACTIONS ON DIELECTRICS AND ELECTRICAL INSULATION IEEE USA, vol. 15, no. 6, décembre 2008 (2008-12), - décembre 2008 (2008-12) pages 1634-1639, ISSN: 1070-9878
- RONOLD W P KING: "The Conical Antenna as a Sensor or Probe" IEEE TRANSACTIONS ON ELECTROMAGNETIC COMPATIBILITY, IEEE SERVICE CENTER, NEW YORK, NY, US, vol. EMC-10, no. 1, 1 février 1983 (1983-02-01), pages 8-13, XP011165109 ISSN: 0018-9375 cité dans la demande
- PALUD S ET AL: "A Novel Broadband Eighth-Wave Conical Antenna" IEEE TRANSACTIONS ON ANTENNAS AND PROPAGATION, IEEE SERVICE CENTER, PISCATAWAY, NJ, US, vol. 56, no. 7, 1 juillet 2008 (2008-07-01), pages 2112-2116, XP011229728 ISSN: 0018-926X
- WEI CHENG ET AL: "Design of a compact and broadband conical monopole antenna" ANTENNAS AND PROPAGATION SOCIETY INTERNATIONAL SYMPOSIUM, 2009. APSURSI '09. IEEE, IEEE, PISCATAWAY, NJ, USA, 1 juin 2009 (2009-06-01), pages 1-4, XP031536439 ISBN: 978-1-4244-3647-7

## Description

### DOMAINE TECHNIQUE

La présente invention concerne un dispositif de surveillance d'un poste électrique haute tension isolé au gaz par mesures de décharges partielles, et un poste électrique haute tension isolé au gaz mettant en oeuvre ce dispositif.

### ÉTAT DE LA TECHNIQUE ANTÉRIEURE

Le domaine de l'invention est celui de la surveillance d'appareillages électriques de type blindé, avec une isolation gazeuse comme par exemple de l'hexafluorure de soufre.

La mesure de décharges partielles permettant la surveillance d'équipements haute tension isolés au gaz est largement utilisée. Mais il existe aujourd'hui un besoin de capteurs de faible prix avec un grand gain et une large bande passante : par exemple de 100 MHz à 2 GHz. En plus on trouve le besoin de mesurer des signaux a des fréquences industrielles simultanément à des signaux a des fréquences UHF (« Ultra High Frequencies »).

Le document référencé [1] en fin de description décrit un dispositif de mesure d'impulsions de tension dues à des décharges partielles dans un appareillage électrique isolé au gaz, au moyen d'un diviseur de tension capacitif, ce dispositif étant disposé dans une ouverture existant dans cet appareillage électrique. Ce dispositif de forme conique comprend une électrode en forme de disque et une plaque intégrée dans une bride de fixation à l'appareillage électrique. Ses caractéristiques sont données par la capacitance entre la bride et l'électrode et par la capacitance entre un conducteur interne à l'appareillage électrique et l'électrode et par le rapport des diamètres des pièces de raccord de la bride et de l'électrode. L'électrode ne fait pas saillie dans l'enceinte de l'appareillage. L'utilisation d'une bride de fixation spéciale prouve qu'un tel dispositif de mesure est influencé par l'environnement. Or, une telle bride spéciale n'est ni économique ni intéressante pour la remise à neuf d'équipement électrique ancien.

D'autres capteurs de l'art connu, installés directement dans l'enceinte d'un poste électrique isolé au gaz nécessitent une modification de toute l'enceinte en cas de maintenance ou de remise à neuf.

Dans le domaine de la transmission des ondes électromagnétiques, les antennes monopolaire (ou « monopôle ») ou dipolaire (ou « dipôle ») de forme conique sont connues pour être de bonnes antennes large bande. Leur impédance d'entrée peut être ajustée en jouant sur leur angle d'ouverture. Leur longueur définit leur sensibilité pour des fréquences basses. Le document référencé [2] montre comment réaliser une telle antenne lorsqu'elle est utilisée sur un plan de masse plat et sans obstacles métalliques dans le champ proche de l'antenne.

Le document référencé [3] conclut qu'un tel capteur peut être utilisé dans un transformateur de puissance rempli d'huile. Une longueur de capteur de 100 mm est proposée comme optimale pour des transformateurs. L'angle d'ouverture est limité à 7 degrés à cause des dimensions de la vanne de purge. Avec un tel petit angle d'ouverture, l'effet large bande en comparaison avec l'antenne unipolaire à simple fil est donc marginale.

Pour l'application interne à un poste isolé au gaz il serait intéressant d'utiliser l'ouverture cylindrique du poste isolé au gaz comme plan de masse. Malheureusement dans ces conditions et du fait qu'il y a dans le poste isolé au gaz d'autres parties métalliques dans l'environnement de l'antenne (par exemple conducteur de courant, brides et fenêtres d'ouverture, commutateurs de mise à la terre etc...), les formules mentionnées dans le document référencé [2] ne peuvent être utilisées. De plus le point d'entrée non idéal et les lignes d'alimentation qui doivent être étanches au gaz à des pressions élevées doivent être pris en considération. Pour quelques postes isolés au gaz, une longueur de capteur de 100 mm est trop longue à cause de leur réalisation compacte et de leur tension de claquage observée à l'intérieur de composants isolés au gaz.

La présente invention montre comment une antenne conique peut être intégrée dans un environnement de poste isolé au gaz bien que les formules théoriques ne puissent être utilisées pour la réalisation. On pourrait montrer que l'environnement de l'antenne (par exemple un arrière plan arrondi) a une influence tellement grande que les formules de forme fermée de la théorie des antennes classiques ne peut être utilisée. Par des mesures on pourrait observer que la sensibilité du capteur peut être adaptée à l'environnement par l'angle d'ouverture mais que les résultats ne suivent pas les formules théoriques mentionnées dans le document référencé [2] à cause de l'influence des capacités parasites entre évidement et tête de capteur. L'angle d'ouverture peut donc être adapté pout obtenir la meilleure sensibilité mais non en fonction des règles théoriques. La meilleure adaptation à un environnement haute tension en utilisant des têtes de capteur plus courtes mais arrondies sont également décrites.

L'invention a pour objet de palier les inconvénients des dispositifs de l'art connu et de construire un capteur de champ électrique large bande, par exemple entre 100 MHz et 2 GHz, and high sensitivity, utilisable simultanément comme diviseur de tension capacitif pour des fréquences industrielles, et bien adapté pour une application à un poste électrique isolé au gaz, plusieurs composants de ce capteur étant des composants commerciaux haute fréquence, à faible coût.

### EXPOSÉ DE L'INVENTION

L'invention concerne un dispositif de surveillance d'un poste électrique haute tension isolé au gaz par mesure de décharges partielles comprenant une enceinte, caractérisé en ce qu'il comprend un capteur de champ électrique comportant une plaque métallique fixée sur la paroi de l'enceinte, une partie conique métallique fermée, dans sa partie évasée, par un couvercle, faisant saillie dans l'enceinte et débouchant, de l'autre coté, sur une traversée traversant la plaque métallique qui sert d'arrière-plan à l'antenne conique ainsi formée, et un connecteur relié à la traversée qui permet de raccorder la traversée à un appareil de mesure et d'affichage via un câble coaxial.

Dans différents modes de réalisation avantageux le capteur peut être fixé dans une ouverture existant dans l'enceinte du poste. Le couvercle peut avoir une forme sphérique, ou une forme plate. L'impédance du capteur, celle de la traversée et celle du câble de connexion peut être est la même. L'angle d'ouverture du cône, formé par la partie conique, peut être compris entre 10° et 47°. La hauteur du capteur peut être comprise entre 20 mm et 250 mm en fonction de l'intensité de champ diélectrique près de la tête du capteur. Le capteur peut être fixé sur la plaque métallique. La traversée peut comprendre un manchon isolant, plus long que son conducteur intérieur de manière à rejoindre et à fixer la partie conique. Le dispositif de l'invention peut comprendre un élément court circuit connecté au travers une ligne de transmission de longueur λ/4, λ étant la longueur d'onde correspondant à la fréquence centrale du capteur, en parallèle au connecteur et à la borne de raccordement du câble. Le dispositif peut comprendre une résistance ohmique connectée en parallèle au connecteur et à la borne de raccordement du câble. Tous les éléments de transmission de signal, tels que le capteur, la traversée, le connecteur et le câble, peuvent avoir la même impédance.

L'invention concerne également un poste électrique haute tension isolé au gaz mettant en oeuvre au moins un tel dispositif, connecté à un appareil de signalisation et de contrôle.

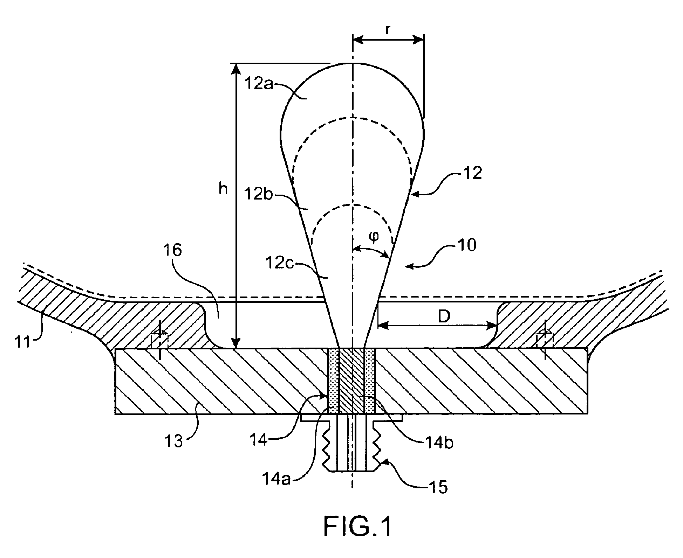

L'invention présente les avantages suivants :
- L'impédance d'entrée du dispositif de l'invention peut être ajustée en modifiant l'angle d'ouverture de la partie conique, ce qui rend facile l'adaptation d'impédance au câble coaxial sans réflexion en entrée.
- L'antenne conique ainsi constituée présente une très grande largeur de bande. Il n'y a pas de limite supérieure pour les fréquences. La gamme de fréquences basses est seulement donnée par la hauteur de la partie conique.
- La sensibilité du dispositif de l'invention peut être ajustée en modifiant la longueur du capteur et l'angle d'ouverture ϕ.
- Dans un premier mode de réalisation de l'invention, tel qu'illustré sur la figure 1, on obtient un dispositif très linéaire qui permet de calculer le champ électrique incident à partir des données mesurées. Ce dispositif peut donc être utilisé comme une sonde champ électrique.
- Le capteur est de petite taille, facile à fabriquer et à assembler et particulièrement bien adapté pour une remise à neuf de vieux postes électriques isolés au gaz.
- Le couvercle de la partie conique, lorsqu'il est arrondi et due à des procédés de coupe/tournage, est bien adapté à un environnement haute tension.
- Le dispositif de l'invention peut être utilisé pour de faibles fréquences, ou fréquences industrielles, (par exemple 50/60 Hz et les ondes harmoniques) pour lesquelles il travaille comme un diviseur de tension capacitif. Il peut aussi être utilisé pour des fréquences plus élevées. S'il est seulement utilisé dans la gamme de fréquences UHF, les faibles fréquences peuvent être supprimées en utilisant un transformateur en λ/4 placé sur le connecteur.

### BRÈVE DESCRIPTION DES DESSINS

La figure 1 illustre un premier mode de réalisation du dispositif de l'invention.
La figure 2 illustre un second mode de réalisation du dispositif de l'invention.
La figure 3 illustre la mise en oeuvre du dispositif de l'invention dans une application triphasée.
La figure 4 illustre la mise en oeuvre du dispositif de l'invention avec un transducteur λ/4 utilisé dans la gamme des fréquences UHF.
La figure 5 illustre le dispositif de l'invention intégré directement dans l'enceinte ou le revêtement d'un poste électrique isolé au gaz, sans utiliser de plaque métallique.

### EXPOSÉ DÉTAILLÉ DE MODES DE RÉALISATION PARTICULIERS

Un poste électrique haute tension isolé au gaz standard comprend au moins un conducteur disposé dans une enceinte 11. Cette enceinte peut comporter des ouvertures pour permettre notamment la fixation de dispositifs de sûreté, et de fenêtres.

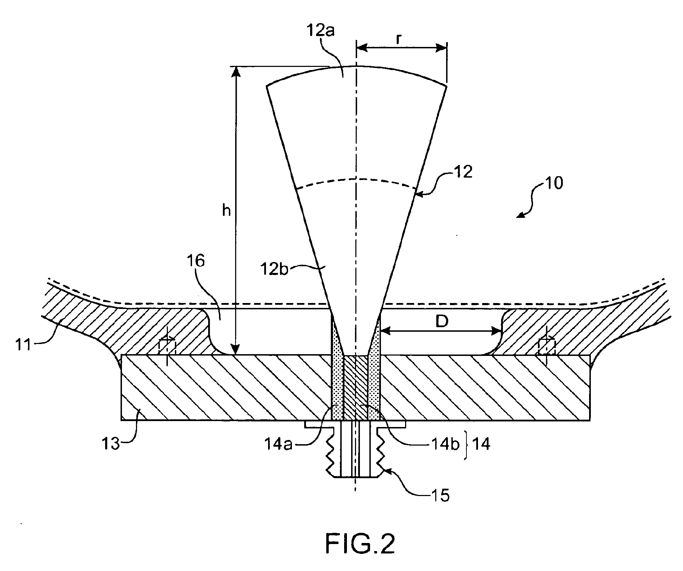

Comme illustré sur la figure 1, dans un premier mode de réalisation, et sur la figure 2, dans un second mode de réalisation, le dispositif de l'invention comprend un capteur de champ électrique (« E-field sensor ») 10, comportant une plaque métallique 13 apte à être fixée sur la paroi 11 de l'enceinte du poste électrique haute tension, une partie conique métallique 12 fermée, dans sa partie évasée, par un couvercle et débouchant, de l'autre coté, sur une traversée 14 traversant la plaque métallique 13, qui sert d'arrière-plan à l'antenne conique ainsi formée, et un connecteur 15 relié a la traversée 14. Ce connecteur 15 permet de raccorder la traversée 14 à un appareil de mesure et d'affichage via un câble coaxial, non représentés sur les figures.

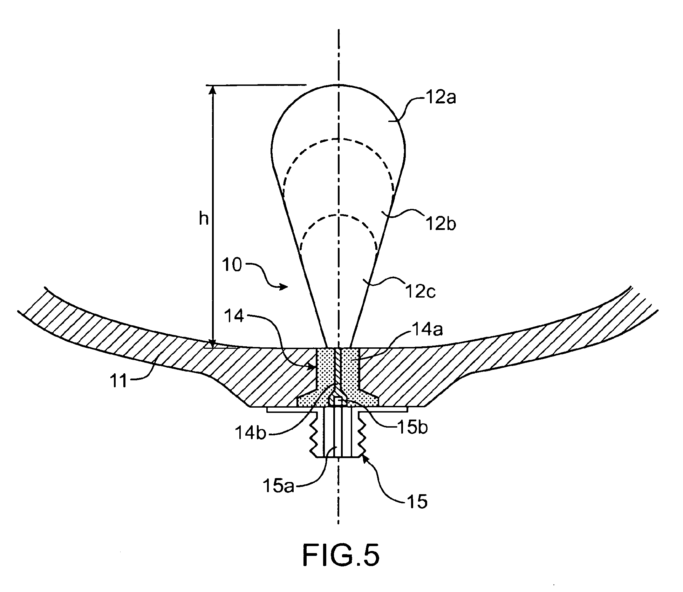

La figure 5 illustre un autre mode de réalisation, le capteur 10 étant fixé directement à l'enceinte 11 d'un poste électrique isolé au gaz (sans plaque métallique). Le manchon 14a et le conducteur intérieur 14b de la traversée 14 forment une bague. Ils peuvent être poussés de l'extérieur de l'enceinte 11 dans un trou de perçage. Le capteur 10 est fixé sur la traversée 14 à partir de l'intérieur de l'enceinte 11. Le conducteur intérieur 14b a une partie filetée (non montrée sur la figure) qui peut être vissée dans le capteur 10. La partie intérieure 15a du connecteur 15 est équipée avec une broche élastique 15b pour faire le contact avec le conducteur intérieur 14a. Le rapport des diamètres du manchon 14a et du conducteur intérieur 14b reste constant de façon à maintenir une impédance d'onde constante le long de ce conducteur intérieur 14b.

Dans ces différents modes de réalisation, la partie conique métallique fermée 12 forme une antenne monopôle (12a à 12c) normalement disposée dans la direction radiale de l'enceinte du poste électrique isolé au gaz.

La partie conique du capteur peut ainsi faire saillie dans l'enceinte du poste électrique isolé au gaz et avoir une plus faible distance jusqu'à un conducteur interne à ce poste électrique isolé au gaz parce que le capteur est fabriqué avec une surface lisse (faible rugosité de surface due à des procédés de coupe/tournage), contrairement à des batis soudés ou moulés. Le capteur 10 et la traversée 14 au travers de la paroi 11 de l'enceinte sont adaptés à l'impédance du câble coaxial de mesure.

L'angle d'ouverture ϕ de la partie conique 12 est compris entre 10° et 47°. La hauteur h du capteur par rapport à la plaque d'arrière-plan 13 est comprise entre 20 mm et 250 mm en fonction de l'emplacement du capteur à l'intérieur de l'enceinte du poste électrique isolé au gaz et de sa distance au conducteur haute tension le plus proche. La sensibilité du capteur 10 peut être influencée en changeant l'angle d'ouverture ϕ et la hauteur h.

Le dispositif de l'invention est spécialement conçu pour des fréquences situées entre 100 MHz et 2 GHz, mais il peut être utilisé en même temps ou de façon indépendante dans une application à fréquences industrielles et ondes harmoniques pour laquelle il fonctionne comme un diviseur de tension capacitif.

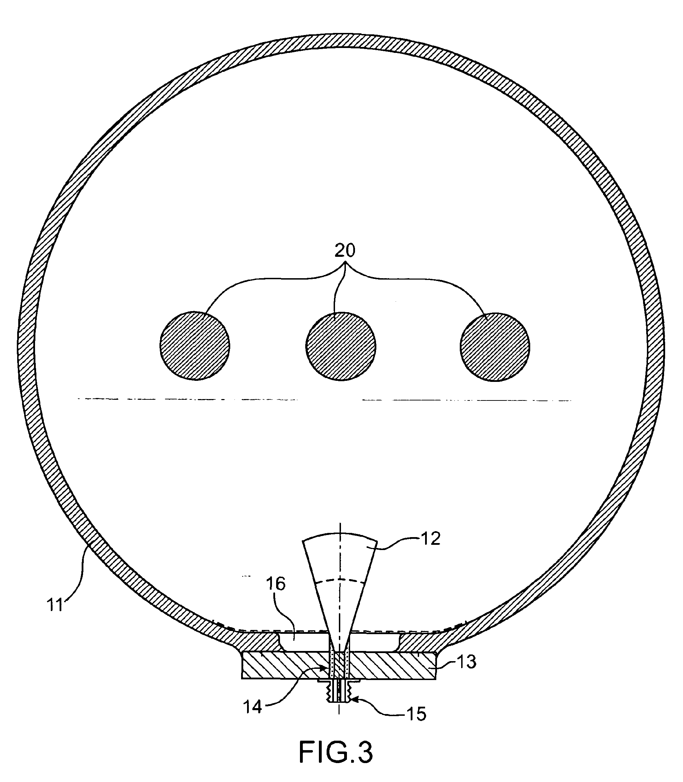

Dans une application monophasée, la hauteur h est typiquement de 45 mm (référence 12c), de telle sorte que la distance au conducteur haute tension le plus proche est réduite à environ 20 mm contre la paroi 11 de l'enceinte qui a une plus grande rugosité. Dans une application triphasée, la hauteur h peut être beaucoup plus grande (référence 12a) en fonction des conducteurs 20 véhiculant les phases à l'intérieur de l'enceinte, illustrés sur la figure 3.

Le rayon r du couvercle de la partie conique 12 est au moins égal à 5 mm et la distance D du capteur à la partie de la paroi 11 de l'enceinte mise à la terre la plus proche est supérieure à ce rayon r. Dans un mode de réalisation avantageux, la traversée 14, étanche au gaz, se compose d'un manchon 14a et un conducteur intérieur 14b. Le manchon 14a est réalisé en un matériau isolant avec un permittivité relative εr comprise entre 2 et 4. Le diamètre du conducteur intérieur 14b est typiquement 6 mm. Le diamètre du matériau isolant dépend de l'impédance de la traversée 14 et l'impédance du connecteur 15. La traversée 14, le connecteur haute fréquence 15 (par exemple de type N), l'impédance d'entrée de l'antenne conique 12 et le câble de mesure coaxial ont typiquement une impédance de 50 ohms, bien que les impédances de la traversée 14 et du point d'entrée de l'antenne puissent être différentes pour réaliser un circuit résonant pour optimiser la sensibilité à des fréquences spécifiques.

Dans le premier mode de réalisation du capteur 10, illustré sur la figure 1, la partie conique 12 du capteur 10 à la forme d'un cône avec un couvercle sphérique, dont le rayon est donné par l'angle d'ouverture ϕ de la partie conique 12 et par sa hauteur h. Dans ce mode de réalisation, on ajuste la forme du capteur 10 au champ électrique produit par une simple antenne en tige monopôle.

Dans le second mode de réalisation du capteur 10, illustré sur la figure 2, la partie conique 12 du capteur 10 se termine par un couvercle sphérique plat ce qui permet d'élargir la partie conique de l'antenne ainsi formée. Le manchon 14a de la traversée 14 peut être plus longue que le conducteur intérieur 14b de cette traversée 14 jusqu'à atteindre la partie conique 12. Dans ce mode de réalisation le manchon 14a peut servir à fixer la partie conique 12.

Dans un mode de réalisation des moyens de connexion selon les figures 1 à 3 et 5, un câble coaxial (non représenté sur les figures) est connecté au connecteur 15. Dans ce mode des signaux hautes fréquences (UHF) et des signaux de fréquences industrielles peuvent être mesurés simultanément. Le gain de signal est influencé par la hauteur h et l'angle ϕ du capteur 10.

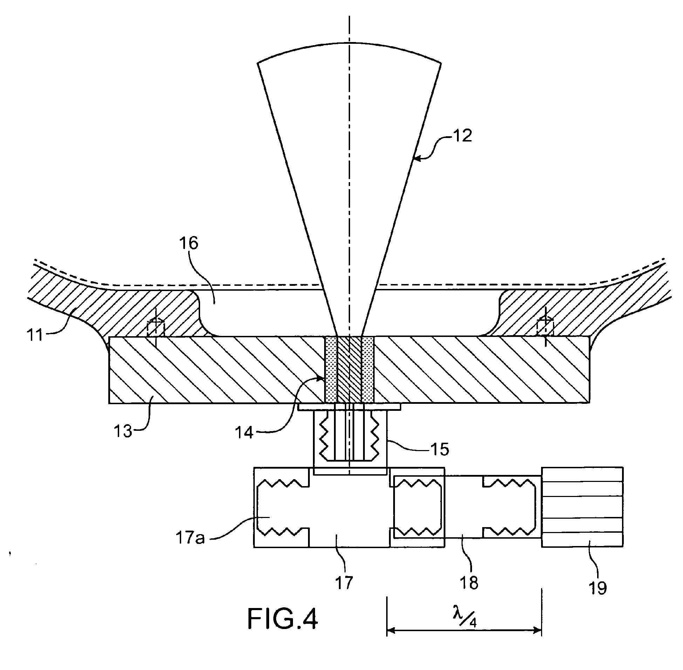

Dans un autre mode de réalisation des moyens de connexion, si le capteur 10 est utilisé uniquement pour les mesures UHF (ultra hautes fréquences), alors les fréquences plus basses peuvent être éliminées en utilisant un jeu de connecteurs/adaptateurs haute fréquence 17, 18, 19 illustrés sur la figure 4 : à savoir un adaptateur en T haute fréquence standard 17, une ligne de transmission 18 de longueur définie et un court-circuit 19. La longueur de la ligne de transmission 18, qui peut être un câble, un connecteur adaptateur (par exemple un adaptateur N-BNC) ou une ligne de transmission quelconque, est conçu pour que le court-circuit 19 fonctionne pour les fréquences basses et des fréquences hautes mais pas pour la fréquence centrale du capteur. La longueur de la ligne de transmission 18 entre le court-circuit 19 et l'adaptateur en T 17 est d'environ 20 à 30 mm de long pour une fréquence centrale de 1 GHz et un adaptateur 17 50 ohms standard, 17A étant la borne de raccordement du câble. Tous ces éléments 17, 18 et 19 sont disponibles dans le commerce.

Dans un autre mode de réalisation des moyens de connexion, une connexion de sortie résistive coaxiale disponible dans le commerce (par exemple une résistance 50 ohms ou 75 ohms) peut être installée à la place de la ligne de transmission 18 et du court-circuit 19 illustrés sur la figure 4. Dans ce cas la tension faible fréquence induite n'est pas éliminée mais abaissée à des valeurs qui peuvent être traitées par un appareil de mesure ou de détection de tension standard. Pour des fréquences élevées l'utilisation d'une telle connexion réduit la sensibilité en fonction de la valeur de la résistance. Dans un ensemble 50 ohms la réduction est de typiquement 3dB pour des fréquences plus élevées.

On peut avantageusement jouer sur différentes caractéristiques du capteur 10 :
- avec l'angle d'ouverture ϕ on peut changer l'impédance point d'entrée du capteur 10, et on peut adapter le capteur 10 à son voisinage (par exemple à des parties élevées de la paroi 11 au potentiel de terre)
- avec sa hauteur h on peut changer sa sensibilité pour des fréquences plus basses mais aussi l'impédance point d'entrée. Cette hauteur h est limitée du fait que les conducteurs haute tension sont situés près du capteur 10,
- en utilisant un adaptateur en T 17 en sortie du capteur avec une ligne de transmission 18 d'une longueur donnée et un court-circuit 19, on peut éviter de réduire la sensibilité du capteur 10 dans une gamme de fréquences spécifique, fonction de la longueur de la ligne de transmission 18 et de son impédance caractéristique (ensemble connu comme un transformateur en λ/4).

### REFERENCES

[1] EP 0 134 187 ou US 4,617,513
[2] Ronold W.P. King, The Conical Antenna as a Sensor or Probe, IEEE Trnasactions on Electromagnetic Compatibility, Vol. EMC-25, No. 1, February 1983, pages 8 - 13
[3] J. Lopez-Roldan et al., Optimisation of a Sensor for Onsite Detection of Partial Discharges in Power Transformers by the UHF Method, IEEE Transactions on Dielectrics and Electrical Insulation, Vol. 15, No. 6, December 2008, pages 1635 - 1639.

## Revendications

1. Dispositif de surveillance d'un poste électrique haute tension isolé au gaz par mesure de décharges partielles comprenant une enceinte (11), **caractérisé en ce qu'**il comprend un capteur de champ électrique (10) comportant une plaque métallique (13) fixée sur la paroi de l'enceinte (11), une partie conique métallique (12) fermée, dans sa partie évasée, par un couvercle, faisant saillie dans l'enceinte et débouchant, de l'autre coté, sur une traversée (14) traversant la plaque métallique (13), qui sert d'arrière-plan à l'antenne conique ainsi formée, et un connecteur (15) relié a la traversée (14) qui permet de raccorder la traversée (14) à un appareil de mesure et d'affichage via un câble coaxial.

2. Dispositif selon la revendication 1, dans lequel le capteur (10) est fixé dans une ouverture existant dans l'enceinte du poste.

3. Dispositif selon la revendication 1, dans lequel le couvercle a une forme sphérique.

4. Dispositif selon la revendication 1, dans lequel le couvercle a une forme plate.

5. Dispositif selon a revendication 1, dans lequel l'impédance du capteur (10), celle de la traversée (14) et celle du câble coaxial est la même.

6. Dispositif selon la revendication 1, dans lequel l'angle d'ouverture ϕ du cône formé par la partie conique (12) est compris entre 10° et 47°.

7. Dispositif selon la revendication 1, dans lequel la hauteur h du capteur (10) est comprise entre 20 mm et 250 mm.

8. Dispositif selon la revendication 3, dans lequel le capteur (10) est fixé sur la plaque métallique (13).

9. Dispositif selon la revendication 1, dans lequel la traversée (14) comprend un manchon isolant (14a) et un conducteur intérieur (14b).

10. Dispositif selon la revendication 9, dans lequel le manchon isolant (14a) est plus long que le conducteur intérieur (14b), ce qui permet de rejoindre et de fixer la partie conique (12).

11. Dispositif selon l'une quelconque des revendications précédentes comprenant un élément court circuit (19) connecté au travers une ligne de transmission de longueur λ/4, λ étant la longueur d'onde correspondant à la fréquence centrale du capteur, en parallèle au connecteur (15) et à la borne de raccordement du câble (17a).

12. Dispositif selon l'une quelconque des revendications précédentes comprenant une résistance connectée en parallèle au connecteur (15) et à la borne de raccordement du câble (17a).

13. Dispositif selon l'une quelconque des revendications précédentes, dans lequel tous les éléments de transmission de signal ont la même impédance.

14. Poste électrique haute tension isolé au gaz mettant en oeuvre au moins un dispositif selon l'une quelconque des revendications 1 à 13, connecté à un appareil de signalisation et de contrôle.

## Claims

1. A device for monitoring gas-insulated high-voltage electrical switchgear by measuring partial discharges, the switchgear including an enclosure (11), the device being **characterized in that** it includes an electric field sensor (10) having a metal plate (13) fastened to the wall of the enclosure (11), a metal conical portion (12) that is closed in its flared portion by a cover protecting into the enclosure and opening at its other end into a bushing (14) passing through the metal plate (13), which plate serves as a back-plane for the conical antenna as formed in this way, and a connector (15) connected to the bushing (14) and enabling the bushing (14) to be connected to a measurement and display device via a coaxial cable.

2. The device according to claim 1, wherein the sensor (10) is fastened into an opening existing in the enclosure of the switchgear.

3. The device according to claim 1, wherein the cover has a spherical shape.

4. The device according to claim 1, wherein the cover has a flat shape.

5. The device according to claim 1, wherein the impendance of the sensor (10), that of the bushing (14), and that of the coaxial cable are the same.

6. The device according to claim 1, wherein the cone angle ϕ of the cone formed by the conical portion (12) is from 10° to 47°.

7. The device according to claim 1, wherein the height h of the sensor (10) is from 20 mm to 250 mm.

8. The device according to claim 3, wherein the sensor (10) is fastened to the metal plate (13).

9. The device according to claim 1, wherein the bushing (14) includes an insulating sleeve (14a) and an internal conductor (14b).

10. The device according to claim 9, wherein the insulating sleeve (14a) is longer than the internal conductor (14b), which enables connection and fastening of the conical part (12).

11. The device according to any preceding claim including a short-circuit element (19) connected via a transmission line of length λ/4, λ being the wavelength corresponding to the center frequency of the sensor, in parallel with the connector (15) and with the connecting terminal of the cable (17a).

12. The device according to any preceding claim including a resistance connected in parallel to the connector (15) and to the connecting terminal of the cable (17a).

13. The device according to any preceding claim, wherein all the signal transmission elements have the same impendance.

14. A Gas-insulated high-voltage electrical switchgear using at least one device according to any one of claims 1 to 13 connected to signaling and control equipment.

## Patentansprüche

1. Vorrichtung zur Überwachung einer gasisolierten Hochspannungsanlage durch Messung von Teilentladungen, enthaltend ein Gehäuse (11), **dadurch gekennzeichnet, dass** sie einen elektrischen Feldsensor (10) enthält, der eine an die Wand des Gehäuses (11) befestigte Metallplatte (13) und einen konischen Abschnitt (12) aus Metall aufweist, der in seinem sich erweiternden Bereich mit einer Abdeckung verschlossen ist, in das Gehäuse hineinragt und auf der anderen Seite an einem Durchgang (14) ausmündet, der sich durch die Metallplatte (13) erstreckt und der somit gebildeten konischen Antenne als Untergrund dient, sowie einen mit dem Durchgang (14) verbundenen Verbinder (15), der es ermöglicht, den Durchgang (14) mit einem Mess- und Anzeigegerät über ein Koaxialkabel zu verbinden.

2. Vorrichtung nach Anspruch 1, wobei der Sensor (10) in einer Öffnung befestigt ist, die in dem Gehäuse der Anlage besteht.

3. Vorrichtung nach Anspruch 1, wobei die Abdeckung eine Kugelform hat.

4. Vorrichtung nach Anspruch 1, wobei die Abdeckung eine flache Form hat.

5. Vorrichtung nach Anspruch 1, wobei der Sensor (10), der Durchgang (14) und das Koaxialkabel die gleiche Impedanz haben.

6. Vorrichtung nach Anspruch 1, wobei der Öffnungswinkel ϕ des aus dem konischen Abschnitt (12) gebildeten Konus zwischen 10° und 47° beträgt.

7. Vorrichtung nach Anspruch 1, wobei die Höhe h des Sensors (10) zwischen 20 mm und 250 mm beträgt.

8. Vorrichtung nach Anspruch 3, wobei der Sensor (10) an die Metallplatte (13) befestigt ist.

9. Vorrichtung nach Anspruch 1, wobei der Durchgang (14) eine Isolierhülse (14a) und einen Innenleiter (14b) aufweiset.

10. Vorrichtung nach Anspruch 9, wobei die Isolierhülse (14a) länger ist als der Innenleiter (14b), wodurch der konische Abschnitt (12) angefügt und befestigt werden kann.

11. Vorrichtung nach einem der vorangehenden Ansprüche, enthaltend ein Kurzschlusselement (19), das über eine Übertragungsleitung mit der Länge λ/4, wobei λ die der Bandmittenfrequenz des Sensors entsprechende Wellenlänge ist, mit dem Verbinder (15) und der Anschlussklemme des Kabels (17a) parallel geschaltet ist.

12. Vorrichtung nach einem der vorangehenden Ansprüche, enthaltend einen Widerstand, der mit dem Verbinder (15) und der Anschlussklemme des Kabels (17a) parallel geschaltet ist.

13. Vorrichtung nach einem der vorangehenden Ansprüche, wobei sämtliche Signalübertragungselemente die gleiche Impedanz haben.

14. Gasisolierte Hochspannungsanlage mit zumindest einer Vorrichtung nach einem der Ansprüche 1 bis 13, die an eine Signal- und Kontrolleinrichtung angeschlossen ist.
